# EUROPÄISCHE PATENTSCHRIFT

(11) **EP 1 929 851 B1**
(45) Veröffentlichungstag und Bekanntmachung des Hinweises auf die Patenterteilung: **10.08.2011**
(21) Anmeldenummer: 06792986.9
(22) Anmeldetag: 24.08.2006
(51) Int. Cl.: H05K 13/00, F16M 5/00

(54) **MASCHINENGRUNDKÖRPER UND BESTÜCKSYSTEM ZUM BESTÜCKEN VON SUBSTRATEN MIT ELEKTRISCHEN BAUTEILEN**
MACHINE BODY AND SYSTEM FOR ASSEMBLING ELECTRIC COMPONENT ON A SUBSTRATE
CORPS DE BASE DE MACHINE ET SYSTEME DE PLACEMENT DE COMPOSANTS POUR PLACER DES COMPOSANTS ELECTRIQUES SUR DES SUBSTRATS

(30) Priorität: 30.09.2005 DE 102005046963
(43) Veröffentlichungstag der Anmeldung: 11.06.2008
(73) Patentinhaber: ASM Assembly Systems GmbH & Co. KG, 81379 München (DE)
(72) Erfinder: MEHDIANPOUR, Mohammed, 81829 München (DE); MÜLLER, Werner, 83607 Holzkirchen (DE); STANZL, Harald, 81476 München (DE); TOMAZ, Borislav, 80686 München (DE)
(74) Vertreter: Dilg, Haeusler, Schindelmann Patentanwaltsgesellschaft mbH
(86) Internationale Anmeldenummer: PCT/EP2006/065646
(87) Internationale Veröffentlichungsnummer: WO 2007/039355

(56) Entgegenhaltungen:
- EP-A1- 1 231 828
- DE-B3- 10 232 939
- US-A- 5 950 980

## Beschreibung

Bestücksystem zum Bestücken von substraten mit elektrischen Bauteilen

Die Erfindung betrifft ein Bestücksystem zum Bestücken von Substraten mit elektrischen Bauteilen, welches einen Maschinengrundkörper aufweist.

Im Bereich des Maschinenbaus ist die Verwendung von Beton, insbesondere von Mineralbeton, zur Herstellung von Maschinenbetten bekannt. Mineralbeton erweist sich vor allem wegen seiner Tragfähigkeit, seiner guten Formbarkeit im Abgussverfahren, der geringen Herstellungskosten und der guten Dämpfungseigenschaften für viele Anwendungen im Maschinenbau als geeignetes Material. Beton bzw. Mineralbeton hat jedoch gegenüber Stahl den Nachteil, dass er eine deutlich geringere Biegewechselfestigkeit bzw. einen kleineren E-Modul aufweist. Zur Kompensation dieses Nachteils müssen die Wandstärken hochbelasteter Bereiche eines Maschinenbettes bzw. eines Maschinengrundkörpers aus Beton entsprechend dicker ausgeführt werden. Der Dimensionierung der Wandstärken sind jedoch insbesondere im Bereich der Bestücktechnik wegen des benötigten Mindestbauraumes innerhalb des Maschinenbetts bei gleichzeitig begrenzter Standfläche sehr enge Grenzen gesetzt. Eine Verstärkung der Wandstärken führt nämlich zwangsläufig entweder zu einer Vergrößerung der Standfläche der Maschine oder aber zu einer deutlichen Einschränkung des Bauraumes innerhalb der Maschine. Da die Flächenleistung einer Maschine ein zentrales Kaufkriterium darstellt, kann der Einsatz von Beton bzw. Mineralbeton an dieser Randbedingung scheitern.

Aus dem US Patent US 5,950,980 ist ein Betonsockel für eine Luftkompressor-Einheit bekannt, welche durch ein Metallgerüst unterstützt wird. Weiterhin ist aus der Patentschrift DE 102 32 939 B3 ein Maschinensockel aus Mineralbeton bekannt, welcher Befestigungsstellen zur Montage von Maschinenbaugruppen aufweist und welcher einen metallischen, von außen kontaktierbaren Erdungskörper besitzt. Aus der Europäischen Veröffentlichungsschrift EP 1231 828 A1 ist ein Bestückautomat zur Bestückung von Leiterplatten mit elektronischen Bauelementen bekannt, wobei mittels eines Bestückkopfs Bauelemente von entsprechenden Zuführungen abgeholt und auf einer im Bestückautomaten gehalterten Leiterplatte abgesetzt werden.

Es ist deshalb die Aufgabe der vorliegenden Erfindung, ein Bestücksystem zum Bestücken von Substraten mit elektrischen Bauteilen zu liefern, welche trotz des Einsatzes von Beton eine hohe Flächenleistung aufweisen.

Diese Aufgabe wird durch das Bestücksystem gemäß dem unabhängigen Anspruch gelöst. Vorteilhafte Ausgestaltungen sind Gegenstand der Unteransprüche.

Der Maschinengrundkörper im Bestücksystem nach Anspruch 1 weist einen Rahmen aus metallischem Werkstoff, sowie zwei beabstandete Wangenkörper aus Beton auf. Die beiden Wangenkörper sind durch den Rahmen miteinander verbunden. Durch den so ausgestalteten Maschinengrundkörper wird ein Funktionsraum bzw. Arbeitsraum geschaffen, welcher seitlich durch die beabstandeten Wangenkörper begrenzt ist. Die Wangenkörper stellen somit die seitlichen Begrenzungswände des Maschinengrundkörpers dar. Da diese seitlichen Begrenzungswände bzw. die Wangenkörper in der Bestücktechnik bauraumtechnisch unkritisch sind, können diese erfindungsgemäß aus Beton gefertigt sein. Funktionsteile des Bestücksystems, an welche hohe Anforderungen bezüglich deren Präzision gestellt sind, wie beispielsweise ein Positioniersystem für einen Bestückkopf, können daher an den Wangenkörpern des Maschinengrundkörpers angebracht bzw. gelagert werden. Bezüglich dieser Funktionsteile können die genannten Vorteile des Betons voll ausgenutzt werden. Der bauraumtechnisch eher kritische Arbeitsraum bzw. Mittelbereich des Maschinengrundkörpers, welcher sich zwischen den Wangenkörpern befindet, wird durch den Rahmen aus Metall realisiert. Der Rahmen kann beispielsweise als Stahlguss- oder Stahlschweißkonstruktion wesentlich fester und schlanker ausgeführt werden, als ein entsprechender Körper aus Beton. Dadurch steht, bei gleicher Standfläche, im Mittelbereich des Maschinengrundkörpers ein wesentlich größerer Bauraum zur Verfügung. Bei dem so ausgeführten Maschinengrundkörper können die Vorteile von Beton unter Beibehaltung einer hohen Flächenleistung voll ausgenutzt werden. Der erfindungsgemäße Maschinengrundkörper zeichnet sich ferner durch eine hohe Flexibilität und geringe Herstellungskosten aus. Durch entsprechende Dimensionierung des Rahmens kann die Größe des Maschinengrundkörpers an unterschiedliche Anforderung angepasst werden. Die Gussformen für die Wangenkörper müssen dazu nicht verändert werden, sodass dieselben Gussformen für beliebige Größen des Maschinengrundkörpers verwendet werden können.

Gemäß Anspruch 5 sind die Wangenkörper aus Mineralbeton gefertigt. Mineralbeton ist für die Anwendung im Bereich der Bestücktechnik besonders vorteilhaft, da er sich durch eine hohe Tragfähigkeit und Dauerhaltbarkeit (keine Rissbildung) ausweist.

In einer Ausgestaltung des Maschinengrundkörpers nach Anspruch 6 sind der Rahmen und die Wangenkörper miteinander vergossen. Dazu wird die Rahmenkonstruktion in eine entsprechende Gussform für die Wangenkörper eingelegt und mit dem Beton vergossen. Nach dem Aushärten des Betons führt dies zu einer festen Verankerung der Rahmenkonstruktion mit den Wangenkörpern. Dadurch, dass der Betonguss ein Kaltverfahren darstellt, ergeben sich beim Vergießen des Rahmens mit den Wangenkörpern keine thermischen Spannungen, was eine Nachbearbeitung des Maschinengrundkörpers nach dem Vergießen unnötig macht. Ferner wird durch das Vergießen der Wangenkörper mit dem Rahmen eine hohe Reproduzierbarkeit des Maschinengrundkörpers gewährleistet. Außerdem handelt es sich um eine einfache Fertigungsweise, welche ein zeitaufwändiges Anschrauben oder Verkleben des Rahmens an die Wangenkörper unnötig macht.

Gemäß der Ausführung des Maschinengrundkörpers nach Anspruch 1 weist jeder Wangenkörper eine Führungsfläche auf, an welcher eine Positioniereinrichtung für eine Handhabungseinrichtung des Bestücksystems verschieblich gelagert werden kann. Bei der Handhabungseinrichtung kann es sich beispielsweise um einen Bestückkopf für die elektrischen Bauteile handeln. Die Führungsflächen für die Positioniereinrichtung können durch das Gussverfahren mit höchster Präzision an den Wangenkörpern ausgeformt werden. So können die Führungsflächen bereits in der Gussform als geschliffene Flächen ausgeführt werden, so dass nach dem Aushärten des Betons die Führungsflächen an den Wangenkörpern ohne Nachbearbeitung höchsten Güteanforderungen genügen. Dadurch, dass das Betongussverfahren ein Kaltverfahren darstellt, tritt kein thermischer Verzug oder ein Schrumpfen der Wangenkörper auf, sodass der Maschinengrundkörper auch diesbezüglich keine Nachbearbeitung erfordert. Da die Führungsflächen für die Positioniereinrichtung an den Wangenkörpern angeordnet sind, können neben der hohen Güte der Führungsflächen auch noch die guten Dämpfungseigenschaften des Betons ausgenutzt werden. Dadurch kann der Einfluss störender Schwingungen auf die Positioniereinrichtung deutlich reduziert werden. Beides trägt zu einer erheblichen Verbesserung des gesamten Bestücksystems bei.

Gemäß Anspruch 1 kann der Maschinengrundkörper auch dahingehend ausgestaltet werden, dass jeder Wangenkörper eine erste Aufnahme für eine Transporteinrichtung zum Transport der Substrate aufweist. Analog zu den vorstehenden Ausführungen, können die ersten Aufnahmen für die Transporteinrichtung durch entsprechende Gestaltung der Gussform mit hoher Güte und Präzision an den Wangenkörpern ausgebildet werden. Auch hier ist eine Nachbearbeitung der Aufnahmen nicht nötig. Da die ersten Aufnahmen für die Transporteinrichtung, sowie die Führungsflächen für die Positioniereinrichtung an den Wangenkörpern vorgesehen sind, haben diese eine definierte und unveränderbare relative Lage zueinander. Dies bringt Vorteile bei der Kalibrierung der an den Führungsflächen gelagerten Positioniereinrichtung bezüglich der an den ersten Aufnahmen angeordneten Transporteinrichtung. Dadurch, dass die Transporteinrichtung an den Wangenkörpern aus Beton anbringbar ist, kommen auch hier die guten Dämpfungseigenschaften des Betons zur Geltung. Auch dies trägt zu einer Erhöhung der Prozess-Sicherheit und der Bestückgenauigkeit des Bestücksystems bei.

Der Maschinengrundkörper kann gemäß Anspruch 7 derart ausgebildet werden, dass zumindest ein Wangenkörper eine zweite Aufnahme für eine Zuführeinrichtung zum Zuführen der elektrischen Bauteile aufweist. Hinsichtlich der Vorteile, welche sich daraus ergeben, dass die zweite Aufnahme an den Wangenkörpern aus Beton vorgesehen ist, wird auf die schon beschriebenen Vorteile bezüglich Anspruch 1 verwiesen. Diese Vorteile gelten auch analog für die Ausgestaltungen des Maschinengrundkörpers nach Anspruch 7.

Gemäß einer Ausgestaltung des Maschinengrundkörpers nach Anspruch 8 weist zumindest ein Wangenkörper Mittel zum lösbaren Koppeln des Grundkörpers an einen Gestellkörper des Bestücksystems auf. Diese Mittel sind derart ausgebildet, dass in einem Zustand, in dem der Maschinengrundkörper an den Gestellkörper gekoppelt ist, der Rahmen mit dem Gestellkörper nicht in Kontakt steht. Dies ist deshalb notwendig, weil nur unter dieser Voraussetzung die günstigen Dämpfungseigenschaften des Betons voll zur Wirkung kommen. Erschütterungen, welche beispielsweise von der Standfläche des Bestücksystems über den Gestellkörper auf den Maschinengrundkörper übertragen werden, werden durch den Beton gedämpft, so dass diese Schwingungen kaum negative Einflüsse auf die Bestückgenauigkeit haben. Würde der Gestellkörper jedoch mit dem Metallrahmen in Verbindung stehen, könnten derartige Schwingungen praktisch ungedämpft auf die Funktionsteile des Bestücksystems, wie beispielsweise das Positioniersystems, die Transporteinrichtung für die Substrate und die Zuführeinrichtungen übertragen werden.

Gemäß Anspruch 9 sind die Mittel zum lösbaren Koppeln als Metallhülsen ausgeführt, welche in den jeweiligen Wangenkörper eingegossen sind. Diese Ausgestaltung weist sich durch eine einfache Fertigungsweise aus, da die Metallhülsen während des Gießvorganges des Maschinengrundkörpers einfach mit in die Gussform eingelegt und von dem Beton umgossen werden. Dadurch, dass der Betonguss ein Kaltverfahren ist, ergeben sich auch hier keinerlei thermische Spannungen, so dass die Metallhülsen mit hoher Präzision mit den Wangenkörpern verbunden werden können.

In einer Ausgestaltung des Maschinengrundkörpers nach Anspruch 10 ist dieser mit Schnittstellen bzw. Anschlüsse für elektrische Energie und Druckluft ausgestattet, welche derart am Maschinengrundkörper angeordnet sind, dass sie in einem Zustand, in dem der Maschinengrundkörper mit dem Gestellkörper gekoppelt ist, die Schnittstellen für Energie und Druckluft mit einer Energieversorgung und einer Druckluftversorgung verbunden sind. Durch diese Ausgestaltung ergibt sich eine schnelle Auswechselbarkeit des Maschinengrundkörpers in einer Fertigungslinie. Der Maschinengrundkörper wird beim Entfernen von dem Gestellkörper automatisch von der Energieversorgung und der Druckluftversorgung getrennt bzw. beim Aufsetzen auf den Gestellkörper in der Fertigungslinie automatisch mit der Energieversorgung und der Druckluftversorgung verbunden. Ein zeitaufwändiges Verbinden der Energieversorgung und der Druckluftversorgung ist dadurch nicht mehr nötig.

Anspruch 1 betrifft ein Bestücksystem zum Bestücken von Substraten mit elektrischen Bauteilen, welches einen Masohinengrundkörper gemäß der vorstehenden Beschreibung aufweist. Die ersten Aufnahmen für die Transporteinrichtung zum Transport der Substrate sind als Aussparungen in den jeweiligen Wangenkörpern ausgebildet. Dadurch kann die Transporteinrichtung durch die Wangenkörper hindurch in einer Transportrichtung verlegt werden. Dabei liegt die Transporteinrichtung sicher auf den Aufnahmen der Wangenkörper auf und ist an diesen sicher befestigt. Ferner umfasst das Bestücksystem eine Positioniereinrichtung für einen Bestückkopf, welche an dem Maschinengrundkörper derart angebracht ist, dass sie entlang der Führungsflächen verschiebbar ist. Zwischen den Wangenkörpern ist ein Raum derart ausgebildet, dass von der Transporteinrichtung transportierte Substrate in diesem Raum von dem Bestückkopf bestückbar sind. Bei dem erfindungsgemäßen Bestücksystem sind die Funktionsteile, wie die Positioniereinrichtung und die Transporteinrichtung, an den Wangenkörpern gelagert bzw. befestigt. Wie bezüglich der vorhergehenden Ansprüche schon ausgeführt wurde, können die Führungsflächen bzw. die ersten Aufnahmen durch das Gussverfahren mit hoher Präzision an den Wangenkörpern ausgebildet werden. Dadurch ist die relative Lage der an den Führungsflächen gelagerten Positioniereinrichtung zu der an den ersten Aufnahmen befestigten Transporteinrichtung präzise und unveränderbar vorgegeben. Dadurch ergeben sich eine sehr hohe Reproduzierbarkeit des Bestückvorganges und Vorteile bei der Kalibrierung. Der Maschinengrundkörper des Bestücksystems weist ferner Mittel zum lösbaren Koppeln des Grundkörpers an den Gestellkörper auf. Dadurch kann der gesamte Maschinengrundkörper schnell und einfach vom Gestellkörper getrennt und aus der Fertigungslinie entfernt werden. Dies gewährleistet einen schnellen Austausch des gesamten Maschinengrundkörpers zusammen mit den daran gelagerten bzw, befestigten Funktionsteilen, d.h. der Positioniereinrichtung und der Transporteinrichtung, als eine Funktionseinheit. Dadurch ist es möglich, den Maschinengrundkörper zusammen mit der Positioniereinrichtung und der Transporteinrichtung außerhalb der Fertigungslinie als eine Funktionseinheit vollständig vorzukalibrieren. Zum Auswechseln des Maschinengrundkörpers wird der außerhalb der Fertigungslinie vorkalibrierte Maschinengrundkörper mit der Positioniereinrichtung und der Transporteinrichtung auf den Gestellkörper in der Fertigungslinie gesetzt werden. Der Bestückprozess kann daher nach einem sehr kurzen Stillstand wieder fortgeführt werden, da eine Kalibrierung der Positioniereinrichtung und der Transporteinrichtung innerhalb der Fertigungslinie nicht mehr nötig ist. Durch die erheblich kürzeren Stillstandzeiten wird der gesamte Fertigungsprozess effektiver gestaltet.

Gemäß dem Anspruch 2 kann das Bestücksystem auch dahingehend ausgestaltet werden, dass zumindest ein Wangenkörper zweite Aufnahmen aufweist, an welchem zumindest eine Zuführeinrichtung für die elektrischen Bauteile derart angeordnet ist, dass die Bauteile von der Zuführeinrichtung durch den Bestückkopf abholbar sind. Gemäß dieser Ausgestaltung ist die Zuführeinrichtung auch direkt an den Wangenkörper angebracht. Dadurch kann die oben erwähnte Vorkalibrierung außerhalb der Fertigungslinie auch bezüglich der Zuführeinrichtung durchgeführt werden. Bei dieser Vorkalibrierung werden nun die Positioniereinrichtung, die Transporteinrichtung und die Zuführeinrichtung relativ zueinander kalibriert. Dadurch ergeben sich analog die bezüglich Anspruch 11 erläuterten Vorteile.

Gemäß den Ausgestaltungen des Bestücksystems nach den Ansprüchen 3 and 4 ist dem Maschinengrundkörper eine Speichereinrichtung zugewiesen, in der Kalibrierdaten abspeicherbar sind. Diese Speichereinrichtung ist beispielsweise an dem Maschinengrundkörper selbst angebracht. Der Maschinengrundkörper kann Datenschnittstellen aufweisen, welche derart angeordnet sind, dass in einem Zustand, in welchem der Maschinengrundkörper mit dem Gestellkörper des Bestücksystems gekoppelt ist, die Speichereinrichtung über die Datenschnittstelle von einer dem Bestücksystem zugeordneten Steuereinrichtung auslesbar ist. Wird der Maschinengrundkörper mit der Positioniereinrichtung, der Transporteinrichtung und optional mit der Zuführeinrichtung als Funktionseinheit außerhalb der Fertigungslinie vorkalibriert, können diese Kalibrierdaten in der Speichereinrichtung abgespeichert werden. Nach dem Einsetzen des Maschinengrundkörpers auf dem Gestellkörper können die Daten über die Datenschnittstelle von der Steuereinrichtung ausgelesen und verwertet werden. Der Auswechselvorgang des Maschinengrundkörpers mit den Funktionselementen wird dadurch erheblich vereinfacht und verkürzt.

Im Folgenden wird die Erfindung anhand der beigefügten Figuren näher erläutert. In den Figuren sind:
Figur 1 eine schematische Perspektivansicht eines Ausführungsbeispiels des erfindungsgemäßen Maschinengrundkörpers,
Figur 2 eine schematische Darstellung des erfindungsgemäßen Maschinengrundkörpers mit einer daran angebrachten Positioniereinrichtung, einer Transporteinrichtung und Zuführeinrichtungen,
Figur 3 eine Darstellung der Unterseite des Maschinengrundkörpers aus Figur 1,
Figur 4 eine schematische Darstellung des erfindungsgemäßen Bestücksystems.

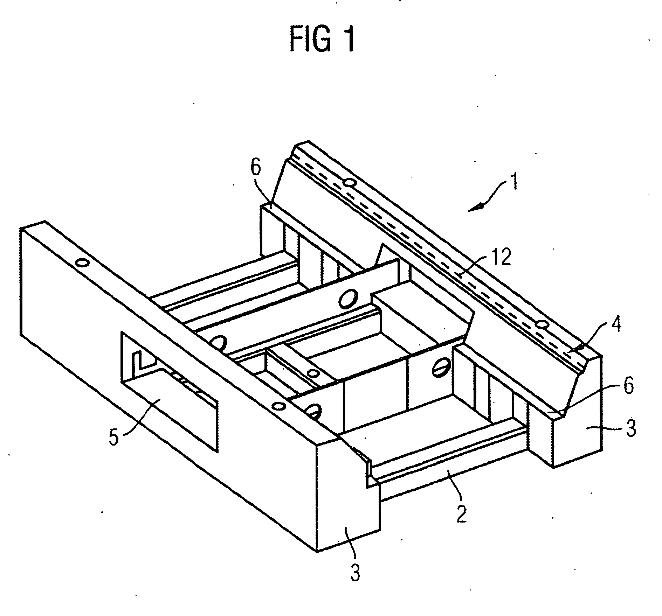

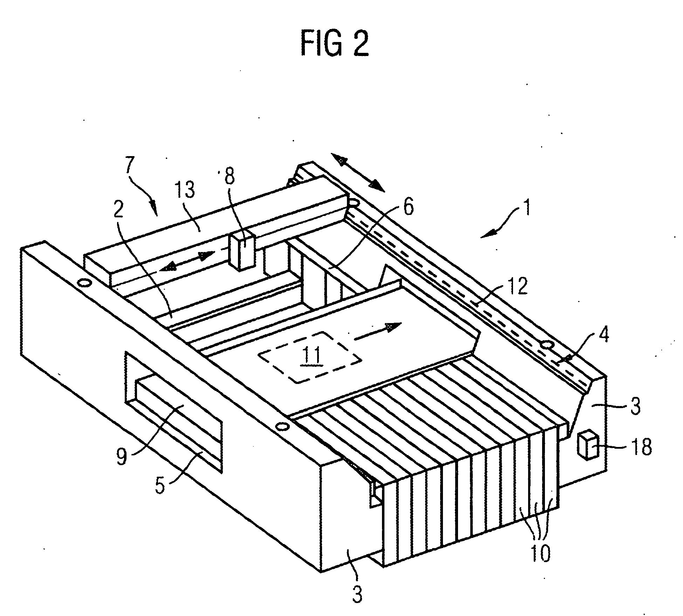

In Figur 1 ist ein Ausführungsbeispiel eines erfindungsgemäßen Maschinengrundkörpers 1 für ein Bestücksystem zum Bestücken von Substraten mit elektrischen Bauteilen schematisch dargestellt. Der Maschinengrundkörper 1 umfasst einen Rahmen 2, welcher beispielsweise als Stahlguss- oder Stahlschweißkonstruktion ausgeführt werden kann. Zum Maschinengrundkörper 1 zählen ferner zwei beabstandete Wangenkörper 3, welche aus Beton gefertigt sind und durch den Rahmen 2 verbunden sind. Für den Einsatz in der Bestücktechnik eignet sich insbesondere Mineralbeton, da er sich durch geringen Preis, gute Dämpfungseigenschaften, Formhaltigkeit, Dauerhaltbarkeit (keine Rissbildung) und gute Tragfähigkeit auszeichnet. Jedoch können je nach Anforderungen auch andere Betonsorten verwendet werden, wie beispielsweise Polymerbeton oder Faserbeton, etc. Im Ausführungsbeispiel ist der Rahmen 2 mit den Wangenkörpern 3 vergossen. Dazu wird der Rahmen 2 in die Gussformen für die Wangenkörper 3 eingelegt und mit dem Mineralbeton umgossen. Durch Aushärten des Mineralbetons entsteht eine äußerst feste Verbindung zwischen dem Rahmen 2 und den Wangenkörpern 3. Da der Betonguss ein Kaltverfahren darstellt, entsteht in dem Rahmen 2 aus Metall kein thermischer Verzug, so dass es beim Vergießen und auch beim Aushärten zu keinerlei Formveränderungen des Maschinengrundkörpers 1 kommt. Alternativ zum Vergießen des Rahmens mit den Wangenkörpern 3 ist es jedoch auch möglich, den Rahmen 2 durch Schraub- oder Klebeverbindungen mit den Wangenkörpern 3 zu verbinden. Jeder Wangenkörper 3 des Maschinengrundkörpers 1 weist eine Führungsfläche 4, an welcher eine Positioniereinrichtung 7 (siehe Fig. 2) für eine Handhabungseinrichtung, insbesondere einen Bestückkopf 8, verschieblich lagerbar ist und eine erste Aufnahme 5 für eine Transporteinrichtung 9 (siehe Fig. 2) zum Transport der zu bestückenden Substrate 11 auf. Zusätzlich weisen beide Wangenkörper 3 jeweils eine zweite Aufnahme 6 zur Befestigung einer oder mehrerer Zuführeinrichtungen 10 (siehe Fig. 2) zum Zuführen der elektrischen Bauteile auf.

Figur 2 zeigt, wie die Positioniereinrichtung 7 mit dem Bestückkopf 8, die Transporteinrichtung 9 und eine Zuführeinrichtung 10 an dem Maschinengrundkörper 1 angeordnet werden können. In diesem Ausführungsbeispiel sind die ersten Aufnahmen 5 als rechteckige, durchgehende Aussparungen in den Wangenkörpern 3 realisiert und derart ausgebildet, dass die Transporteinrichtung 9 an den ersten Aufnahmen 5 befestigt werden kann ohne mit dem Rahmen 2 aus Metall in Berührung zu kommen. Dies ist insofern wichtig, als dass Schwingungen durch den Mineralbeton sehr gut gedämpft und so kaum auf die Transporteinrichtung 9 übertragen werden. Dies bringt erhebliche Vorteile für die Präzision des Bestückvorgangs. Sollte es dennoch nötig sein, die Transporteinrichtung 9 zwischen den beiden Aufnahmen an dem Rahmen 2 abzustützen, so sollten diese Stützpunkte auf ein Minimum begrenzt und eventuell mit Dämpfungselementen ergänzt werden. Mittels der Transporteinrichtung 9 können die Substrate 11 (gestrichelt dargestellt) in einer Transportrichtung (durch Pfeil A dargestellt) durch den zwischen den Wangenkörpern 3 ausgebildeten Raum hindurchtransportiert werden.

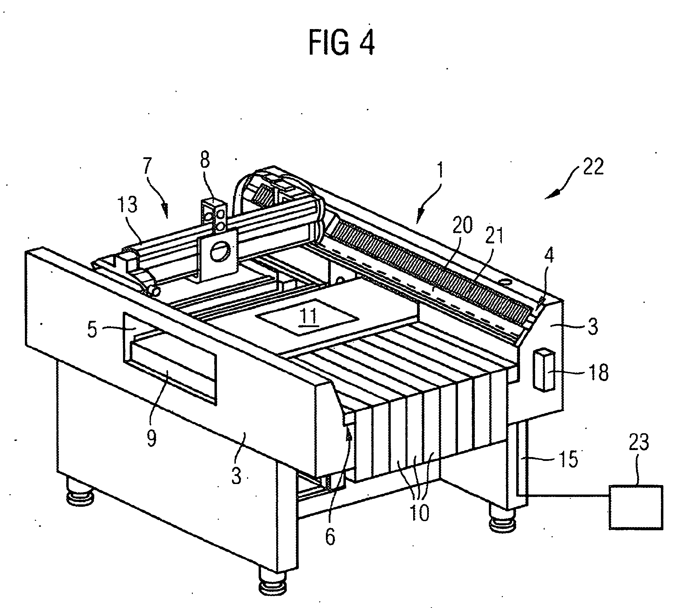

Wie aus Figur 2 deutlich wird, sind die Führungsflächen 4 der Wangenkörper 3 quer zur Transportrichtung der Transporteinrichtung 9 ausgerichtet. An den Führungsflächen 4 sind Montagehilfen 12, wie beispielsweise Bohrungen, zur Befestigung entsprechender Führungselemente 20 (siehe Figur 4) oder Antriebseinrichtungen 21 (siehe Figur 4) für das Positioniersystem vorgesehen. Ein Trägerarm 13 der Positioniereinrichtung 7 stützt sich an beiden Enden an den Führungsflächen 4 ab und erstreckt sich dabei in einer Richtung parallel zur Transportrichtung der Substrate 11. Der Bestückkopf 8 ist am Trägerarm 13 in einer zur Transportrichtung der Substrate 11 parallelen Richtung verschiebbar angebracht. Durch diese Ausgestaltung des Maschinenkörpers können die mittels der Transporteinrichtung 9 eingebrachten Substrate 11 in dem zwischen den beiden Wangenkörpern 3 ausgebildeten Raum durch den Bestückkopf 8 mit elektrischen Bauteilen bestückt werden.

Die zur Bestückung notwendigen Bauteile werden durch die an den zweiten Aufnahmen 6 der Wangenkörper 3 befestigte Zuführeinrichtung 10 bereitgestellt. Die zweiten Aufnahmen 6 sind derart angeordnet, dass die Zuführeinrichtungen 10 ausschließlich an den zweiten Aufnahmen 6 der Wangenkörper 3 befestigt sind und mit dem Rahmen 2 nicht in Kontakt kommen. Auch hier liegt der Grund darin, dass keine Schwingungen von dem Rahmen 2 auf die Zuführeinrichtungen 10 übertragen werden sollen.

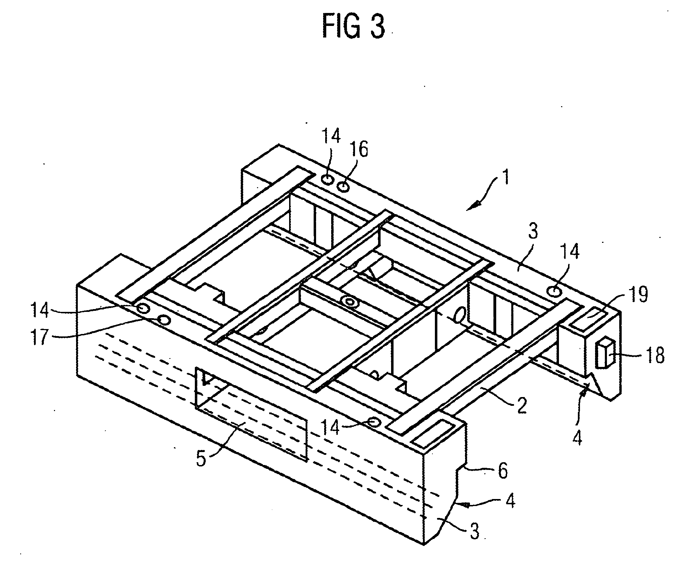

Figur 3 zeigt die Unterseite des in Figur 1 dargestellten Maschinengrundkörpers 1. Die Wangenkörper 3 weisen an der Unterseite Metallhülsen 14 auf, welche schon beim Gießen der Wangenkörper 3 mit dem Mineralbeton vergossen werden. Die Metallhülsen 14 dienen als Mittel zum lösbaren Koppeln des Maschinengrundkörpers 1 an einen Gestellkörper 15 eines Bestücksystems, wie es in Figur 4 dargestellt ist. Wie aus Figur 3 deutlich wird, sind die Metallhülsen 14 ausschließlich an den Wangenkörpern 3 derart vorgesehen, so dass in einem Zustand, in dem der Maschinengrundkörper 1 auf den Gestellkörper 15 gesetzt ist, der Gestellkörper 15 weder mit dem Rahmen 2, noch mit den Funktionsteilen (Transporteinrichtung 9 oder Zuführeinrichtungen 10) in Kontakt steht. Dadurch werden Schwingungen von den Wangenkörpern 3 aus Mineralbeton größtenteils weggedämpft und nicht über den Gestellkörper 15 auf den Rahmen 2 oder die Funktionsteile übertragen. Am Maschinengrundkörper 1 sind ferner Schnittstellen 16, 17 bzw. Anschlüsse für elektrische Energie und Druckluft derart vorgesehen, dass sie in einem Zustand, in dem der Maschinengrundkörper 1 mit dem Gestellkörper 15 über die Metallhülsen 14 gekoppelt ist, mit einer Energieversorgung oder einer Druckluftversorgung (nicht dargestellt) verbunden sind. Über die Anschlüsse für elektrische Energie und Druckluft können entsprechende Verbraucher, wie beispielsweise der Bestückkopf 8 oder die Zuführeinrichtungen 10, über Leitungen (nicht dargestellt) versorgt werden.

An dem Maschinengrundkörper 1 ist ferner eine Speichereinrichtung 18 vorgesehen, in der Kalibrierdaten bezüglich der Positioniereinrichtung 7, der Transporteinrichtung 9 und der Zuführeinrichtungen 10 abgespeichert werden können. Die Speichereinrichtung 18 ist mit einer Datenschnittstelle 19 verbunden, welche derart an dem Maschinengrundkörper 1 angeordnet ist, dass in einem Zustand, in dem der Maschinengrundkörper 1 mit dem Gestellkörper 15 (siehe Figur 4) gekoppelt ist, die Speichereinrichtung 18 über die Datenschnittstelle 19 von einer dem Bestücksystem zugeordneten Steuereinrichtung 23 (siehe Fig. 4) ausgelesen werden kann.

In Figur 4 ist ein Ausführungsbeispiel eines erfindungsgemäßen Bestücksystems 22 dargestellt. Das Bestücksystem 22 umfasst den Gestellkörper 15, einen wie oben beschriebenen Maschinengrundkörper 1, sowie die Positioniereinrichtung 7 mit dem Bestückkopf 8, welche an den Führungsflächen 4 der Wangenkörper 3 gelagert ist, die Transporteinrichtung 9, welche an den ersten Aufnahmen 5 der Wangenkörper 3 befestigt ist, sowie mehrere Zuführeinrichtungen 10, welche an den zweiten Aufnahmen 6 der Wangenkörper 3 angeordnet sind. Auf den Führungsflächen 4 der Wangenkörper 3 sind Führungselemente 20 und Antriebseinrichtungen 21, wie beispielsweise stationäre Teile eines Linearmotors, für die Positioniereinrichtung 7 vorgesehen. Darüber hinaus können auch Messeinrichtungen wie beispielsweise ein Linearmaßstab an der Führungsfläche 4 angeordnet werden.

Dadurch, dass an dem Maschinengrundkörper 1 wichtige Funktionsteile des Bestücksystems 22, wie die Positioniereinrichtung 7 mit dem Bestückkopf 8, die Transporteinrichtung 9 für die Substrate 11 sowie die Zuführeinrichtungen 10 verankert sind, kann dieser zusammen mit den Funktionsteilen als eine Funktionseinheit von dem Gestellkörper 15 genommen werden. In einer Fertigungslinie (nicht dargestellt), bestehend aus mehreren hintereinander angeordneten erfindungsgemäßen Bestücksystemen, ist dadurch ein schneller Austausch der einzelnen Funktionseinheiten möglich. Die Funktionseinheiten werden einfach von den Gestellkörpern genommen und durch eine andere ersetzt. Ferner erlaubt es das erfindungsgemäße Bestücksystem 22, die Funktionseinheit außerhalb der Fertigungslinie komplett vorzukalibrieren. Die gewonnenen Kalibrierungsdaten können in der der Funktoneinheit eindeutig zugeordneten Speichereinrichtung 18 am Maschinengrundkörper 1 abgespeichert werden. Beim Aufsetzen auf den Gestellkörper 15 ist die Funktionseinheit dann auch gleich mit einer Druckluftversorgung und einer elektrischer Energieversorgung verbunden. Die in der Speichereinrichtung 18 abgespeicherten Kalibrierdaten können über die Datenschnittstelle 19 durch die Steuereinrichtung 23 ausgelesen werden. Ein zeitaufwändiges Kalibrieren innerhalb der Fertigungslinie ist nicht mehr notwendig. Dadurch ergeben sich erhebliche Zeitvorteile beim Austausch eines Bestücksystems 22.

### Bezugszeichenliste:

- 1: Maschinengrundkörper
- 2: Rahmen
- 3: Wangenkörper
- 4: Führungsfläche
- 5: erste Aufnahme
- 6: zweite Aufnahme
- 7: Positioniereinrichtung
- 8: Bestückkopf
- 9: Transporteinrichtung
- 10: Zuführeinrichtung
- 11: Substrate
- 12: Montagehilfen
- 13: Trägerarm
- 14: Metallhülsen
- 15: Gestellkörper
- 16: Schnittstelle für elektrische Energie
- 17: Schnittstelle für Druckluft
- 18: Speichereinrichtung
- 19: Datenschnittstelle
- 20: Führungselemente
- 21: Antriebseinrichtung
- 22: Bestücksystem
- 23: Steuereinrichtung

## Patentansprüche

1. Bestücksystem (22) zum Bestücken von Substraten mit elektrischen Bauteilen, mit
- einem Gestellkörper (15)
- einem Maschinengrundkörper (1) mit einem Rahmen (2), welcher Metall aufweist sowie zwei beabstandeten Wangenkörpern (2), welche Beton aufweisen und durch den Rahmen (2) verbunden sind, wobei
- jeder Wangenkörper (3) eine Führungsfläche (4) aufweist, an welcher eine Positioniereinrichtung (7) für eine Handhabungseinrichtung (8) verschieblich lagerbar ist und
- jeder Wangenkörper (3) eine erste Aufnahme (5) für eine Transporteinrichtung (9) zum Transport der Substrate (11) aufweist
- wobei der Maschinengrundkörper weiterhin lösbar an den Gestellkörper (15) gekoppelt ist, wobei die ersten Aufnahmen (5) als Aussparungen in den Wangenkörpern (3) ausgebildet sind und zumindest ein Wangenkörper (3) Mittel (14) zum lösbaren Koppeln des Maschinengrundkörpers (1) an den Gestellkörper (15) aufweist,
- einer Positioniereinrichtung (7) für einen Bestückkopf (8), welche an dem Maschinengrundkörper (1) derart angebracht ist, dass sie entlang der Führungsflächen (4) verschiebbar ist,
- einer Transporteinrichtung (9) zum Transport der Substrate (11), welche durch die ersten Aufnahmen (5) der Wangenkörper (3) verläuft,
wobei zwischen den Wangenkörpern (3) ein Raum derart ausgebildet ist, dass von der Transporteinrichtung (9) transportierte Substrate (11) in diesem Raum von dem Bestückkopf (8) bestückbar sind.

2. Bestücksystem (22) nach Anspruch 1, wobei zumindest ein Wangenkörper (3) zweite Aufnahmen (6) aufweist, an welchen zumindest eine Zuführeinrichtung (10) für elektrische Bauteile derart angebracht ist, dass die Bauteile von der Zuführeinrichtung (10) durch den Bestückkopf (8) abholbar sind.

3. Bestücksystem (22) nach einem der Anspruche 1 bis 2, wobei dem Maschinengrundkörper (1) eine Speichereinrichtung (18) zugewiesen ist, in der Kalibrierdaten abspeicherbar sind.

4. Bestücksystem (22) nach einem der Ansprüche 1 bis 3, wobei der Maschinengrundkörper (1) eine Datenschnittstelle (19) aufweist, welche mit der Speichereinrichtung (18) verbunden und derart angeordnet ist, dass in einem Zustand, in dem der Maschinengrundkörper (1) mit dem Gestellkörper (15) gekoppelt ist, die Speichereinrichtung (18) über die Datenschnittstelle (19) von einer dem Bestücksystem (22) zugeordneten Steuereinrichtung auslesbar ist.

5. Bestücksystem (22) nach einem der vorhergehenden Ansprüche, wobei die Wangenkörper (3) aus Mineralbeton bestehen.

6. Bestücksystem (22) nach einem der vorhergehenden Ansprüche, wobei der Rahmen (2) und die Wangenkörper (3) miteinander vergossen sind.

7. Bestücksystem (22) nach einem der vorhergehenden Ansprüche, wobei zumindest ein Wangenkörper (3) eine zweite Aufnahme (6) für eine Zuführeinrichtung (10) zum Zuführen der elektrischen Bauteile aufweist.

8. Bestücksystem (22) nach einem der vorhergehenden Ansprüche, wobei zumindest ein Wangenkörper (3) Mittel (14) zum lösbaren Koppeln des Maschinengrundkörpers (1) an einen Gestellkörper (15) des Bestücksystems (22) aufweist, welche derart ausgebildet sind, dass in einem Zustand, in dem der Maschinengrundkörper (1) an den Gestellkörper (15) gekoppelt ist, der Rahmen (2) mit dem Gestellkörper (15) nicht in Kontakt steht.

9. Bestücksystem (22) nach Anspruch 8, wobei die Mittel (14) zum lösbaren Koppeln Metallhülsen (14) sind, welche in den jeweiligen Wangenkörper (3) eingegossen sind.

10. Bestücksystem (22) nach einem der Ansprüche 1 bis 9, mit Schnittstellen (16), (17) für elektrische Energie und Druckluft, welche derart am Maschinengrundkörper (1) angeordnet sind, dass sie in einem Zustand, in dem der Maschinengrundkörper (1) mit dem Gestellkörper (15) gekoppelt ist, mit einer Energieversorgung und einer Druckluftversorgung verbunden sind.

## Claims

1. Assembly system (22) for assembling substrates with electric components, the assembly system (22) comprising
a base frame body (15),
a machine body (1) having a frame (2) which comprises metal as well as two side plate bodies (3) being separated from each other, wherein the side plate bodies (3) comprise concrete and are connected with each other by means of the frame (2), wherein
each side plate body (3) comprises a guidance face (4) at which a positioning device (7) for a handling device (8) is supported in slidable manner, and
each side plate body (3) comprises a first holding fixture (5) for a transportation device (9) for transporting the substrates (11), wherein
further the machine body (1) is coupled to the base frame body (15) in a detachable manner, wherein the first holding fixtures (5) are formed as recesses within the side plate bodies (3) and at least one side plate body (3) comprises means (14) for coupling the machine body (1) to the base frame body (15) in a detachable manner,
a positioning device (7) for an assembly head (8), which is attached to the machine body (1) in such a manner, that the positioning device (7) is slidable along the guidance faces (4), and
a transportation device (9) for transporting the substrates (11), which runs through the first holding fixtures (5) of the side plate bodies (3),
wherein between the side plate bodies (3) there is formed a space in such a manner, that substrates (11) which have been transported by the transportation device (9) can be assembled in this space by means of the assembly head (8).

2. Assembly system (22) as set forth in claim 1, wherein
at least one side plate body (3) comprises second holding fixtures (6) at which at least on feeding device (10) for electric components is attached in such a manner, that the components can be picked up from the feeding device (10) by means of the assembly head (8).

3. Assembly system (22) as set forth in one of the claim 1 to 2, wherein
a memory device (18) is assigned to the machine body (1), in which calibration data can be stored.

4. Assembly system (22) as set forth in one of the claim 1 to 3, wherein
the machine body (1) comprises a data interface (19) which is connected with the memory device (18) and which is located in such a manner, that in a state, in which the machine body (1) is coupled with the base frame body (15), the memory device (18) can be read out from a control device being assigned to the assembly system (22) via the data interface (19).

5. Assembly system (22) as set forth in one of the preceding claims, wherein the side plate bodies (3) consist of mineral concrete.

6. Assembly system (22) as set forth in one of the preceding claims, wherein the frame (2) and the side plate bodies (3) are teemed with each other.

7. Assembly system (22) as set forth in one of the preceding claims, wherein
at least one side plate body (3) comprises a second holding fixture (6) for a feeding device (10) for feeding the electric components.

8. Assembly system (22) as set forth in one of the preceding claims, wherein
at least one side plate body (3) comprises means (14) for coupling the machine body (1) to the base frame body (15) of the assembly system (22) in a detachable manner, wherein the means (14) are formed in such a manner, that in a state, in which the machine body (1) is coupled to the base frame body (15), the frame (2) is not in contact with the base frame body (15).

9. Assembly system (22) as set forth in claim 8, wherein
the means (14) for coupling in a detachable manner are metal ferrules (14) which are casted integrally within the respective side plate body (3).

10. Assembly system (22) as set forth in one of the claims 1 to 9, further comprising
interfaces (16, 17) for electric energy and compressed air, which are located at the machine body (1) in such a manner, that in a state, in which the machine body (1) is coupled to the base frame body (15), the interfaces (16, 17) are coupled with an energy power supply and a compressed air supply.

## Revendications

1. Système d'équipement (22) destiné à équiper des substrats de composants électriques, comprenant
- un corps de bâti (15)
- un corps de base de machine (1) doté d'un cadre (2) présentant du métal ainsi que de deux corps à feuillures (2) espacés présentant du béton et reliés par le cadre (2),
-- chaque corps à feuillures (3) présentant une surface de guidage (4), sur laquelle un dispositif de positionnement (7) pour un dispositif de manipulation (8) peut être logé de manière mobile et
-- chaque corps à feuillures (3) présentant un premier logement (5) pour un dispositif de transport (9) destiné au transport des substrats (11)
- le corps de base de machine étant couplé en outre de manière amovible au corps de bâti (15), les premiers logements (5) étant réalisés comme des évidements dans les corps à feuillures (3) et au moins un corps à feuillures (3) présentant des moyens (14) pour le couplage amovible du corps de base de machine (1) au corps de bâti (15),
- un dispositif de positionnement (7) pour une tête d'équipement (8) qui est montée sur le corps de base de machine (1) de manière à pouvoir être déplacée le long des surfaces de guidage (4),
- un dispositif de transport (9) destiné au transport des substrats (11), qui s'étend au travers des premiers logements (5) des corps à feuillures (3),
dans lequel un espace est réalisé entre les corps à feuillures (3) de telle manière que des substrats (11) transportés par le dispositif de transport (9) puissent être équipés dans cet espace par la tête d'équipement (8).

2. Système d'équipement (22) selon la revendication 1, dans lequel au moins un corps à feuillures (3) présente des seconds logements (6), sur lesquels au moins un dispositif d'amenée (10) pour des composants électriques est monté de telle manière que les composants puissent être retirés du dispositif d'amenée (10) par la tête d'équipement (8).

3. Système d'équipement (22) selon l'une quelconque des revendications 1 à 2, dans lequel un dispositif d'enregistrement (18), dans lequel peuvent être enregistrées des données de calibrage, est attribué au corps de base de machine (1).

4. Système d'équipement (22) selon l'une quelconque des revendications 1 à 3, dans lequel le corps de base de machine (1) présente une interface de données (19) reliée au dispositif d'enregistrement (18) et disposée de telle manière que dans un état, dans lequel le corps de base de machine (1) est couplé au corps de bâti (15), un dispositif de commande associé au système d'équipement (22) peut lire dans le dispositif d'enregistrement (18) par le biais de l'interface de données (19).

5. Système d'équipement (22) selon l'une quelconque des revendications précédentes, dans lequel les corps à feuillures (3) se composent de grave.

6. Système d'équipement (22) selon l'une quelconque des revendications précédentes, dans lequel le cadre (2) et les corps à feuillures (3) sont scellés les uns aux autres.

7. Système d'équipement (22) selon l'une quelconque des revendications précédentes, dans lequel au moins un corps à feuillures (3) présente un second logement (6) pour un dispositif d'amenée (10) destiné à l'amenée des composants électriques.

8. Système d'équipement (22) selon l'une quelconque des revendications précédentes, dans lequel au moins un corps à feuillures (3) présente des moyens (14) pour le couplage amovible du corps de base de machine (1) à un corps de bâti (15) du système d'équipement (22), lesquels sont réalisés de telle manière que dans un état, dans lequel le corps de base de machine (1) est couplé au corps de bâti (15), le cadre (2) n'est pas en contact avec le corps de bâti (15).

9. Système d'équipement (22) selon la revendication 8, dans lequel les moyens (14) pour le couplage amovible sont des douilles métalliques (14) moulées dans le corps à feuillures respectif (3).

10. Système d'équipement (22) selon l'une quelconque des revendications 1 à 9, présentant des interfaces (16), (17) pour de l'énergie électrique et de l'air comprimé qui sont disposées sur le corps de base de machine (1) de telle manière qu'elles soient reliées dans un état, dans lequel le corps de base de machine (1) est relié au corps de bâti (15), à une alimentation en énergie et à une alimentation en air comprimé.
